# DEMANDE DE BREVET EUROPEEN

(11) **EP 4 528 737 A1**
(43) Date de publication de la demande: **26.03.2025**
(21) Numéro de dépôt: 24200711.0
(22) Date de dépôt: 17.09.2024
(51) Int. Cl.: G11C 11/54, G11C 13/00, G11C 7/10, G06N 3/063, G06N 3/065

(54) **ARCHITECTURE D'UNE MÉMOIRE NON VOLATILE**

(30) Priorité: 22.09.2023 FR 2310039
(71) Demandeur: STMicroelectronics International N.V., 1228 Plan-les-Ouates, Geneva (CH)
(72) Inventeur: LECOQ, Xavier, 38500 VOIRON (FR); RAZAFINDRAIBE, Alin, 38400 SAINT MARTIN D'HERES (FR); JOUANNEAU, Thomas, 38120 ST-EGREVE (FR)
(74) Mandataire: Cabinet Beaumont

(57) **Abrégé**

La présente description concerne un mémoire non volatile (200) comprenant :
- une première zone (202) comprenant une première pluralité d'éléments de stockage configurés pour stocker des valeurs associés à une première pluralité de neurones d'un réseau ;
- une deuxième zone (202') comprenant une deuxième pluralité d'éléments de stockage ;
- un circuit de contrôle (208), configuré pour appliquer, à une pluralité de premiers chemins de lecture, une ou plusieurs premières valeurs d'entrée, chaque premier chemin de lecture comprenant l'une parmi les éléments de stockage de la première pluralité d'éléments ;
- un circuit de calcul (212_1) configuré pour additionner des courants fournis par les premiers chemins pour générer un courant de sortie ; et
- un circuit de programmation configuré pour convertir le courant de sortie en courant de programmation, et de programmer un élément de stockage de la deuxième pluralité d'éléments en utilisant ledit courant de programmation.

## Description

### Domaine technique

La présente description concerne de façon générale des mémoires non volatiles configurées pour effectuer des calculs. En particulier, la présente description concerne une mémoire non volatile configurée pour effectuer des calculs entre plusieurs couches d'un réseau de neurones artificiel.

### Technique antérieure

Le fonctionnement de réseaux de neurones fait généralement appel à l'exécution, par un processeur, d'algorithmes avancés. Les calculs, tels que des convolutions et/ou des calculs matriciels, commandés lors de l'exécution des algorithmes impliquent alors des transferts de données entre une mémoire non volatile et/ou volatile et le processeur. Les données transférées sont, par exemple, des paramètres du réseau de neurones, tels que des poids. Les résultats intermédiaires entre des calculs successifs sont, par exemple, stockés de manière temporaire dans une mémoire volatile.

Chaque transfert de données entre la mémoire non volatile et/ou la mémoire volatile et le processeur est couteux en temps et en consommation d'énergie. Cela entraine, par exemple, des temps de latence dans le traitement de données, par le réseau de neurones, ainsi qu'une performance réduite dans le traitement des données.

Il existe un besoin d'améliorer l'exécution des calculs commandés lors du traitement de données par un réseau de neurones artificiels.

### Résumé de l'invention

Un mode de réalisation prévoit une mémoire non volatile comprenant :
- une première zone comprenant une première pluralité d'éléments de stockage, configurés pour stocker des valeurs de poids associés à une première pluralité de neurones d'un réseau de neurones ;
- une deuxième zone comprenant une deuxième pluralité d'éléments de stockage ;
- un circuit de contrôle, configuré pour appliquer, à une pluralité de premiers chemins de lecture, une ou plusieurs premières valeurs d'entrée, chaque premier chemin de lecture comprenant l'une parmi les éléments de stockage de la première pluralité d'éléments de stockage ;
- un premier circuit de calcul configuré pour additionner des courants fournis par les premiers chemins de lecture pour générer un premier courant de sortie ; et
- un circuit de programmation configuré pour convertir le premier courant de sortie en premier courant de programmation, et de programmer un premier élément de stockage de la deuxième pluralité d'éléments de stockage en utilisant ledit premier courant de programmation.

Selon un mode de réalisation, l'une ou plusieurs premières valeurs d'entrée sont appliquées de manière simultanée aux premiers chemins de lecture.

Selon un mode de réalisation, le circuit de contrôle est en outre configuré pour appliquer, à une pluralité de deuxièmes chemins de lecture, une ou plusieurs deuxième valeurs d'entrée générées en lisant le premier de la deuxième pluralité d'éléments de stockage, chaque deuxième chemin de lecture comprenant l'une parmi les éléments de stockage de la première pluralité d'éléments de stockage,
la mémoire non volatile comprenant en outre
- un deuxième circuit de calcul, configuré pour additionner des courants fournis par les deuxièmes chemins de lecture pour générer un deuxième courant de sortie, le circuit de programmation étant configuré pour convertir le deuxième courant de sortie en deuxième courant de programmation, et de programmer un autre élément de stockage de la première zone de la mémoire en utilisant ledit deuxième courant de programmation.

Selon un mode de réalisation, le circuit de contrôle est en outre configuré pour appliquer, à une pluralité de troisièmes chemins de lecture, une ou plusieurs troisième valeurs d'entrée générées en lisant l'autre élément de stockage de la premier zone, chaque troisième chemin de lecture comprenant l'une parmi les éléments de stockage de la première pluralité d'éléments de stockage, et le premier circuit de calcul est en outre configuré pour additionner des courants fournis par les troisièmes chemins de lecture pour générer un troisième courant de sortie, le circuit de programmation étant en outre configuré pour convertir le troisième courant de sortie en troisième courant de programmation, et de reprogrammer le premier élément de stockage de la deuxième pluralité d'éléments de stockage en utilisant ledit troisième courant de programmation.

Selon un mode de réalisation, les éléments de stockage compris dans les premiers chemins de lecture définissent les poids associés à une couche d'entrée du réseau de neurones et dans laquelle les éléments de stockage compris dans les troisièmes chemins de lecture définissent les poids associés à une autre couche, ou à une couche de sortie, du réseau de neurones.

Selon un mode de réalisation, les poids stockés par la première pluralité d'éléments de stockage définissent des poids de neurones appartenant à des couches de parité impaire, respectivement de parité paire, du réseau de neurones et les poids stockés par la deuxième pluralité d'éléments de stockage définissent des poids de neurones appartenant à des couches de parité paire, respectivement de parité impaire, du réseau de neurones.

Selon un mode de réalisation, chaque élément de stockage, parmi la première et la deuxième pluralité d'éléments de stockage, appartient à une cellule mémoire, chaque cellule mémoire étant reliée au circuit de contrôle par l'intermédiaire d'une ligne de mot et d'une ligne de bit, le circuit de contrôle étant configuré pour activer ou désactiver des lignes de mots et des lignes de bits.

Selon un mode de réalisation, le premier circuit de calcul est configuré pour générer la première valeur de sortie, sur la base des courants fournis par les cellules mémoire comprises dans un chemin de lecture parmi les premiers chemins de lecture.

Selon un mode de réalisation, le circuit de calcul est en outre configuré pour appliquer des effets de compensation et/ou de seuil et/ou de décalage et/ou de mise à l'échelle, sur la base des courants fournis par les cellules mémoire comprises dans un chemin de lecture parmi les premiers chemins de lecture.

Selon un mode de réalisation, les éléments de stockage et les autres éléments de stockage sont des éléments résistifs programmables.

Selon un mode de réalisation, la mémoire ci-dessus comprend en outre un troisième circuit de calcul configuré pour générer une autre valeur de sortie, sur la base de courants fournis par une ou plusieurs cellules mémoire comprises dans un chemin de lecture parmi les premiers chemins de lecture et de l'une ou plusieurs premières valeurs d'entrée.

Selon un mode de réalisation, le premier et le troisième circuits de calcul sont configurés pour générer les valeurs de sortie sur la base d'une ou plusieurs cellules en commun dans la pluralité de premiers chemins de lecture, les cellules en commun étant dupliquées dans au moins deux sous-zones dans la première zone.

Un mode de réalisation prévoit un procédé comprenant :
- l'application, par un circuit de contrôle à une pluralité de premiers chemins de lecture, d'une ou plusieurs premières valeurs d'entrée, chaque premier chemin de lecture comprenant l'une parmi des éléments de stockage d'une première pluralité d'éléments de stockage d'une première zone d'une mémoire non volatile, la première pluralité d'éléments de stockage étant configurés pour stocker des valeurs de poids associés à une première pluralité de neurones d'un réseau de neurones ;
- l'addition, par un premier circuit de calcul, des courants fournis par les premiers chemins de lecture pour générer un premier courant de sortie ;
- la conversion, par un circuit de programmation, le premier courant de sortie en premier courant de programmation, et programmer, par le circuit de programmation, un premier élément de stockage d'une deuxième pluralité d'éléments de stockage d'une deuxième zone de la mémoire non volatile en utilisant ledit premier courant de programmation.

Selon un mode de réalisation, le procédé ci-dessus comprend en outre :
- l'application, par le circuit de contrôle à une pluralité de deuxièmes chemins de lecture, d'une ou plusieurs deuxièmes valeurs d'entrée générées en lisant le premier de la deuxième pluralité d'éléments de stockage, chaque deuxième chemin de lecture comprenant l'une parmi les éléments de stockage de la première pluralité d'éléments de stockage,
- additionner, par un deuxième circuit de calcul, des courants fournis par les deuxièmes chemins de lecture pour générer un deuxième courant de sortie ;
- convertir, par le circuit de programmation, le deuxième courant de sortie en deuxième courant de programmation, et programmer, par le circuit de programmation, un autre élément de stockage de la première zone de la mémoire en utilisant ledit deuxième courant de programmation.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre de manière schématique un réseau de neurones artificiel et représente un exemple d'opérations effectuées par le réseau de neurones artificiel ;
la figure 2 est un schéma par bloc illustrant une mémoire non volatile, selon un mode de réalisation de la présente description ;
la figure 3 illustre une partie de la mémoire non volatile, selon un mode de réalisation de la présente description ;
la figure 4 est un schéma illustrant une pluralité de neurones implémentés directement dans la mémoire non volatile, selon un mode de réalisation de la présente description ;
la figure 5A illustre des calculs effectués entre une première et une deuxième couches du réseau de neurones, selon un mode de réalisation de la présente description ;
la figure 5B illustre des calculs effectués entre la deuxième et une troisième couche du réseau de neurones, selon un mode de réalisation de la présente description ;
la figure 6 est un schéma par bloc illustrant une autre mémoire non volatile, selon un mode de réalisation de la présente description ;
la figure 7A illustre des calculs effectués entre la première et la deuxième couches du réseau de neurones, selon un mode de réalisation de la présente description ; et
la figure 7B illustre des calculs effectués entre la deuxième et la troisième couche du réseau de neurones, selon un mode de réalisation de la présente description.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la programmation d'éléments résistif est connue et à la portée de la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

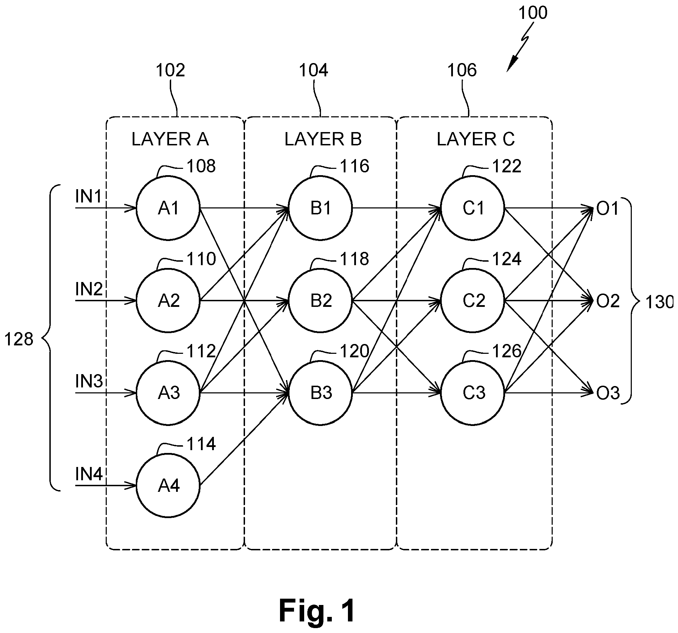

La figure 1 illustre de manière schématique un réseau de neurones artificiel 100 et représente un exemple d'opérations effectuées par le réseau de neurones artificiel 100.

Le réseau de neurones artificiel 100 comprend par exemple une couche 102 (LAYER A), une couche 104 (LAYER B) et une couche 106 (LAYER C). A titre d'exemple, les couches 102 et 106 sont respectivement une couche d'entrée et une couche de sortie du réseau de neurones 100. Dans l'exemple illustré, la couche 102 comprend quatre neurones artificiels 108, 110, 112 et 114 respectivement associés à des poids A1, A2, A3 et A4. La couche 104 comprend trois neurones artificiels 116, 118 et 120 respectivement associés à des poids B1, B2 et B3. La couche 106 comprend trois neurones 122, 124 et 126 respectivement associés à des poids C1, C2 et C3.

A titre d'exemple, un vecteur d'entrée 128 est fourni à la couche 102 du réseau de neurones 100. Le réseau de neurones 100 est alors configuré pour générer un vecteur de sortie 130 sur la base du vecteur d'entrée 128. A titre d'exemple, le vecteur d'entrée 128 comprend des données relatives à une image, une vidéo, ou une bande audio. A titre d'exemple, le vecteur de sortie 130 comprend par exemple des probabilités d'appartenance, d'une cible appartenant à l'image ou à la vidéo, à des catégories, etc. Dans un autre exemple, le réseau de neurones 100 est configuré pour effectuer une reconnaissance vocale, un traitement du langage, une conversion parole-texte ou texte-parole, une traduction, etc., sur la base d'une bande audio.

Dans l'exemple illustré par la figure 1, le vecteur d'entrée 128 comprend quatre valeurs d'entrée IN1, IN2, IN3 et IN4. A titre d'exemple, la couche 102 est configurée pour effectuer une opération linéaire entre le vecteur d'entrée 128 et les poids A1 à A4. A titre d'exemple, la valeur d'entrée IN1 est fournie au neurone 104, configuré pour effectuer la multiplication A1×IN1. De même, chacune des valeurs d'entrée IN2, IN3 ou IN4 est fournie au neurone de poids A2, A3 ou A4 correspondant et qui est configuré pour générer la valeur correspondante IN'2= A2×IN2, IN'3= A3×IN3 ou IN'4= A4×IN4.

A titre d'exemple, le neurone 108 est par exemple configuré pour transmettre la valeur IN'1=A1×IN1 aux neurones 116 et 120 de la couche 104. A titre d'exemple, le neurone 116 reçoit en outre les valeurs IN'2=A2×IN2 et IN'3=A3×IN3. Le neurone 116 est par exemple configuré pour générer une valeur IN"1=B1× (IN'1+IN'2+IN'3) et, par exemple, pour la transmettre au neurone 122 de la couche 106.

Dans l'exemple illustré par la figure 1, le neurone 120 est configuré pour générer une valeur IN''3 sur la base des valeurs fournies par les neurones 108 et 114. A titre d'exemple la valeur IN''3 est égale à la combinaison linéaire B3×(IN'1+IN'4). Le neurone 120 est, par exemple, en outre configuré pour fournir la valeur IN''3 aux neurones 122, 124 et 126 de la couche 106.

Dans l'exemple illustré par la figure 1, le neurone 122 est configuré pour générer une valeur de sortie O1. La valeur de sortie est par exemple une composante du vecteur de sortie 130. A titre d'exemple, la valeur O1 est égale à la combinaison linéaire C1×(IN"1+IN"2+IN"3), où la valeur IN"2 est la valeur générée par le neurone 118, par exemple sur la base des valeurs IN'2 et IN'3 et des poids B2 et B3. De même, les neurones 124 et 126 sont respectivement configurés pour générer des valeurs de sortie O2 et O3, sur la base des poids C2 et C3 et des valeurs IN"1 à IN"3 leur étant fournies.

Le réseau de neurones artificiel 100 est donc, par exemple, configuré pour effectuer des opérations de type multiplier et additionner (en anglais « Multiply and Accumulate » - MAC).

Selon un mode de réalisation, pour éviter les temps de transfert entre une mémoire non volatile stockant les poids des neurones, une mémoire volatile stockant, par exemple, des résultats intermédiaires tels que les valeurs IN'1 à IN'4 et IN"1 à IN"3 et un processeur configuré pour effectuer les opération MAC, les opérations MAC sont directement effectuées dans la mémoire non volatile (en anglais « In Memory Computing » - IMC).

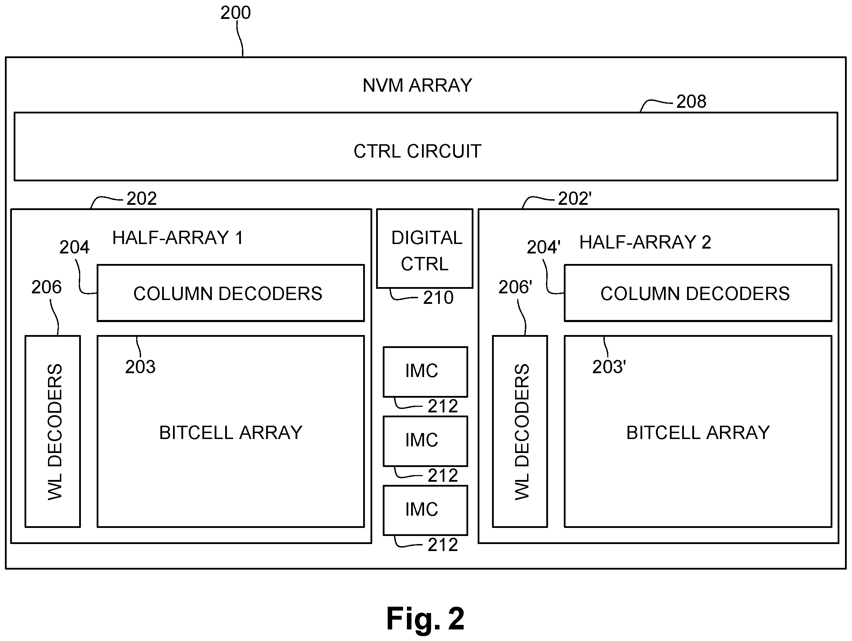

La figure 2 est un schéma par bloc illustrant une mémoire non volatile 200. A titre d'exemple, la mémoire non volatile 200 implémente un réseau de neurones semblable au réseau de neurone 100. A titre d'exemple, le réseau de neurones implémenté dans la mémoire non volatile 200 est un réseau de neurones convolutif (en anglais « Convolutional Neural Network » - CNN), un réseau de neurones complètement connectés (en anglais « Fully Connected Neural Network »), etc. A titre d'exemple, le réseau de neurones implémenté dans la mémoire non volatile 200 est de taille relativement restreinte, comprenant par exemple une dizaine de couches.

Selon un mode de réalisation, la mémoire non volatile 200 comprend deux zones 202 (HALF-ARRAY 1) et 202' (HALF-ARRAY 2). Les zones 202 et 202' comprennent par exemple, chacune, une matrice de cellules mémoire 203 et 203' (BITCELL ARRAY). A titre d'exemple, les matrices de cellules mémoire 203 et 203' comprennent chacune une pluralité de cellules mémoire, ou d'éléments de stockage, adressables en lignes et en colonnes et par l'intermédiaire de lignes de mots et de lignes de bits. Les zones 202 et 202' comprennent, chacune, un décodeur de colonnes 204 et 204' (COLUMN DECODERS) et un décodeur de lignes 206 et 206' (WL DECODERS). Chaque cellule mémoire des matrices 203 et 203' est alors adressable par l'intermédiaire des décodeurs 204 et 206, et 204' et 206'. A titre d'exemple, chaque cellule mémoire implémente un neurone du réseau de neurones 100.

La mémoire 200 comprend en outre un circuit de contrôle 208 (CTRL CIRCUIT) configuré pour commander, par l'intermédiaire d'un circuit digital 210 (DIGITAL CTRL), les décodeurs 204, 206, 204' et 206'. Suite à la commande du circuit de contrôle 208, les décodeurs 204 et 206, 204' et 206' activent alors des chemins de lecture, comprenant une cellule mémoire, dans la matrice 203 ou 203'. Un chemin de lecture correspond, par exemple, à une synapse alimentant un neurone, chaque neurone étant généralement alimenté par plusieurs synapses.

Selon un mode de réalisation, la mémoire 200 comprend en outre au moins un circuit de calcul 212 (IMC). Bien que la figure 2 illustre trois circuits 212, la mémoire 200 peut bien sûr comprendre un nombre supérieur, ou inférieur, de circuits de calcul 212. Dans certains cas, la mémoire 200 comprend une pluralité de circuits de calcul 212. Chaque circuit 212 est relié à un ensemble d'au moins un chemin de lecture dans la matrice 203 et est configuré pour effectuer un ou plusieurs calculs sur la base de l'intensité du courant en sortie de l'ensemble des chemins de lecture. Chaque circuit de calcul 212 est en outre configuré pour générer une valeur, sur la base des courants en sortie de l'ensemble des chemins de lecture. Chaque circuit de calcul 212 est en outre relié à un autre élément de stockage (non illustré en figure 2) compris dans la zone 202' et est configuré pour y stocker la valeur générée. De même, chaque circuit 212 est relié à un ensemble d'au moins un chemin de lecture dans la matrice 203' et est configuré pour effectuer un ou plusieurs calculs sur la base de l'intensité du courant en sortie de l'ensemble des chemins de lecture.

A titre d'exemple la mémoire 200 est placée, par le circuit de contrôle 208, dans des modes de fonctionnement parmi trois modes de fonctionnement. Un mode de calcul permet à la mémoire d'alimenter un ou plusieurs chemins de lecture et permet aux circuits de calculs 212 d'effectuer les uns ou plusieurs calculs. Un mode de programmation permet à la mémoire de programmer des éléments résistifs (non illustrés en figure 2) suite à un ou plusieurs calculs, par les circuits de calculs 212. Un mode de lecture permet la lecture des valeurs programmées dans les éléments résistifs compris dans la mémoire 200.

De manière similaire, la mémoire non volatile 200 comprend d'autres circuits de calcul 212, chacun relié à un ensemble de chemins de lecture dans la matrice 203'. Ces circuits de calcul 212 sont, en outre, configurés pour générer des valeurs sur la base des courants en sortie de l'ensemble des chemins de lecture, et pour stocker ces valeurs dans d'autres éléments de stockage (non illustrés en figure 2) compris dans la zone 202.

Chaque matrice 203 et 203' comprend des cellules mémoire représentant des neurones de plusieurs couches du réseau de neurones. En particulier, chaque matrice 203 et 203' comprend des neurones de couches de même parité. Autrement dit, si la matrice 203 comprend les neurones de la couche d'entrée, par exemple la couche 102, soit la première couche, du réseau de neurones 100, elle comprend aussi les neurones de la troisième couche, par exemple la couche 106, etc. du réseau de neurones 100. La matrice 203 comprend alors la deuxième couche du réseau, par exemple la couche 104, et toute autre couche de parité paire s'il y en a. Dans un autre exemple, les neurones de la couche d'entrée sont compris dans la matrice 203'.

A titre d'exemple, le réseau de neurones implémenté par la mémoire 200 est un réseau de taille relativement réduite, comprenant, par exemple, une dizaine de couches, et par exemple comprenant un total d'au minimum 3 couches et d'au maximum 10 couches.

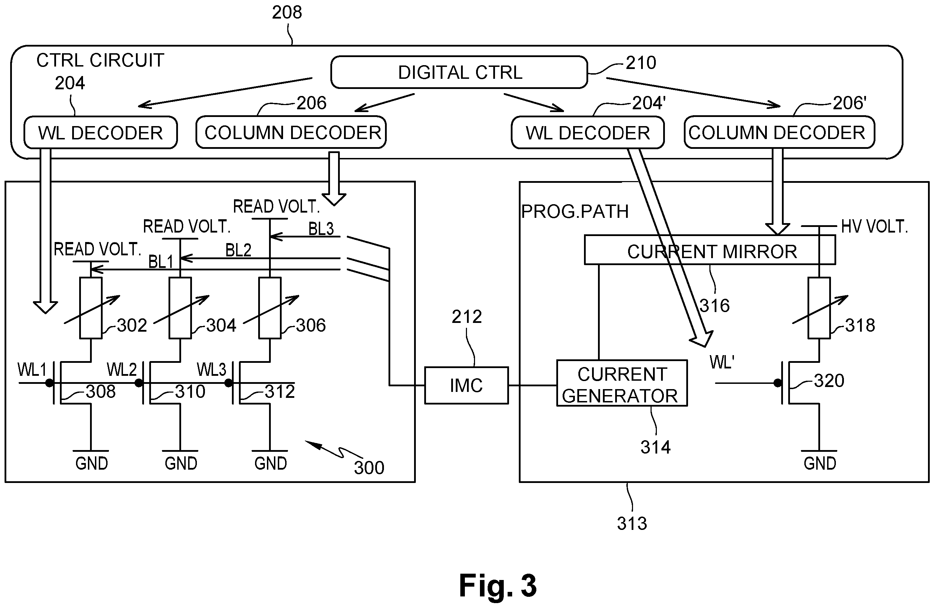

La figure 3 illustre une partie de la mémoire non volatile 200, selon un mode de réalisation de la présente description. En particulier, la figure 3 illustre plus en détail un ensemble de chemins de lecture 300, compris dans la matrice 203 et relié à un circuit de calcul 212.

A titre d'exemple, l'ensemble de chemins de lecture 300 comprend des éléments résistifs 302, 304 et 306 de différentes résistances encodant les poids de trois neurones d'une couche du réseau de neurones. Chaque élément résistif 302, 304 et 306 est respectivement relié par ses électrodes à la source, ou au drain, d'un transistor 308, 310 et 312 et à une ligne de bit BL1, BL2 et BL3 à laquelle est appliquée une tension de lecture (READ VOLT.). Les éléments résistifs 302, 304 et 306 sont par exemple respectivement alimentés par les lignes de bits BL1, BL2 et BL3, par l'intermédiaire de la tension de lecture. Les transistors 308, 310 et 312 ont respectivement chacun leur grille reliée à une ligne de mots WL1, WL2 et WL3. Les transistors 308, 310 et 312 sont en outre reliés à la masse (GND) par leur drain ou leur source. A titre d'exemple, les lignes de mots WL1, WL2 et WL3 sont distinctes les unes des autres. Dans un autre exemple, au moins deux éléments résistifs 302, 304 ou 306 sont reliés à une même ligne de mots. Le circuit de contrôle 208 est par exemple configuré pour commander, par l'intermédiaire du circuit digital 210, l'alimentation des lignes de mots WL1, WL2 et WL3. A titre d'exemple, pour commander l'alimentation des lignes de mots, le circuit de contrôle 208 place la mémoire 200 dans un mode de calcul.

Le circuit de contrôle 208 est en outre configuré, par l'intermédiaire du circuit digital 210 et du décodeur 206, pour fournir le courant en sortie de chaque élément résistif 302, 304 et 306 à un des circuits de calcul 212. Le circuit de calcul 212 est par exemple configuré pour générer un courant en fonction des courants en sortie des éléments 302, 304 et 306. A titre d'exemple, le courant généré par le circuit 212 est fonction d'une somme des courants en sortie des éléments 302, 304 et 306. A titre d'exemple, le circuit de calcul 212 comprend en outre un amplificateur de courant configuré pour amplifier la somme des courants en sortie des éléments 302, 304 et 306. A titre d'exemple, le circuit de calcul 212 est en outre configuré pour appliquer des effets de compensation et/ou de seuil et/ou de décalage et/ou de mise à l'échelle, sur la base des courants en sortie des éléments 302, 304 et 306.

Le circuit de calcul 212 est par exemple configuré pour fournir le courant généré à un circuit de programmation 313 (PROG. PATH). Le circuit de programmation est, par exemple, compris dans la zone 202'.

A titre d'exemple, le circuit de programmation 313 comprend un générateur de courant 314 (CURRENT GENERATOR). Par exemple, une valeur de courant de référence du générateur de courant 314 est égale au, ou fonction du, courant fourni par le circuit de calcul 212.

Le circuit de programmation 313 comprend, par exemple, en outre un miroir de courant 316 (CURRENT MIRROR). A titre d'exemple, le miroir de courant 316 est relié au générateur de courant 314 et est configuré pour dupliquer le courant en sortie du générateur de courant 314.

Dans d'autres modes de réalisation, le circuit 314 est omis, par exemple si le miroir de courant 316 est configuré pour appliquer un gain entre le courant fourni par le circuit de calcul 212 et le courant fourni à l'élément de stockage 318.

Le miroir de courant 316 est en outre relié à un autre élément résistif 318 et est configuré pour programmer cet autre élément résistif 318 à une valeur de résistance en fonction du courant généré par le circuit de calcul 212. Par exemple, le générateur de courant 314 est configuré pour générer un courant de programmation sur la base du courant fourni par le circuit de calcul 212. A titre d'exemple, l'élément résistif 318 est un élément reprogrammable plusieurs fois, et le circuit de programmation 313 est configuré pour reprogrammer l'élément résistif 318 à partir d'une valeur de résistance courante vers la nouvelle valeur de résistance sur la base du courant de programmation.

L'élément résistif 318 est relié par une de ses électrodes à une tension de référence (HV VOLT.) et, par l'autre de ses électrodes, à la source, ou au drain, d'un transistor 320. A titre d'exemple, la tension de référence est appliquée à l'élément résistif 318 uniquement lorsque le circuit de contrôle 208 est dans un état de programmation. Le transistor 320 est par exemple relié à la masse par son drain, ou sa source, et sa grille est par exemple reliée à une ligne de mots WL'. La ligne de mots WL' est par exemple commandée par le décodeur 204'. Le décodeur colonne 206' est par exemple configuré pour sélectionner la bonne colonne à connecter au miroir de courant 316. Le décodeur de colonne 206' est en outre configuré pour sélectionner le chemin reliant les cellules.

La valeur à laquelle l'élément résistif 318 est programmé correspond par exemple à une valeur d'entrée pour la couche suivante du réseau de neurones. A titre d'exemple, en relation avec la figure 1, les éléments résistifs 302, 304 et 306 programment, respectivement, les poids des neurones 108, 110 et 112. Les lignes de bits BL1, BL2 et BL3 fournissent alors, respectivement, un courant I1, I2 et I3, fonction des états des transistors 308, 310 et 312 et des éléments résistifs 302, 304 et 306. L'ensemble de chemins de lecture 300 correspond alors à la combinaison des neurones 108, 110 et 112 reliés au neurone 116 de la couche 104. Le circuit de calcul 212 est alors, par exemple, configuré pour effectuer l'opération de couche entre les couches 102 et 104. A titre d'exemple, l'opération de couche correspond à la somme des produits poids-valeurs d'entrées pour les neurones 108, 110 et 112. Le courant généré par le circuit de calcul encode la valeur d'entrée IN'1+ IN'2+IN'3. L'élément résistif 318 est donc configuré pour stocker, temporairement, la valeur d'entrée du neurone 116 de la couche 104. Dans un autre exemple, les éléments résistifs 302, 304 et 306 encodent, respectivement les poids des neurones 116, 118 et 120 et le circuit de calcul 212 est configuré pour générer une valeur correspondante à la valeur IN"1+IN"2+IN"3. A titre d'exemple, le circuit de calcul 212 est un noeud reliant les lignes de bits de chaque chemin de lecture. Dans d'autres cas, le circuit de calcul 212 intègre d'autres fonctions qui modifient la somme des courants en sortie de l'ensemble des chemins de lecture 300. L'élément résistif 318 est alors configuré pour stocker la valeur d'entrée de neurone 122 de la couche 106.

La mémoire 200 comprend donc une pluralité d'ensemble de chemins de lecture, semblables à l'ensemble 300, bien que le nombre d'éléments résistifs diffère d'ensemble de chemins à l'autre. Chaque ensemble de chemins est par exemple relié à un circuit de calcul 212. Chaque circuit 212 est configuré pour fournir un courant utilisé pour la programmation d'une valeur, correspondant à une valeur d'entrée pour un, ou plusieurs, neurones de la couche suivante, dans un élément résistif semblable à l'élément 318.

La valeur programmée dans l'élément 318 est fournie, sous forme de courant généré par l'intermédiaire du miroir de courant 316 et du générateur de courant 314 à la matrice 203' de la figure 2, sous le contrôle des décodeurs 204' et en activant une ou plusieurs lignes de mots de la matrice 203'.

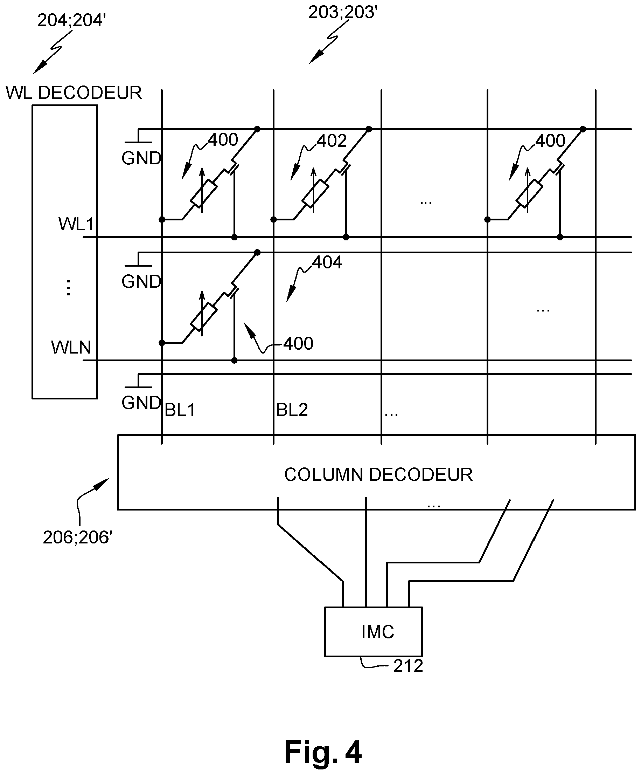

La figure 4 est un schéma illustrant une pluralité de neurones implémentés directement dans la mémoire non volatile. En particulier, la figure 4 illustre un exemple de la structure des matrices 203 et 203'.

Chacune des matrices 203 et 203' comprend une pluralité de cellules mémoire 400 adressables en lignes et en colonnes. Toutes les cellules d'une même ligne de la matrice 203 ou 203' sont par exemple reliées à une même ligne de mots (WL1,..., WLN), N étant un entier égal au nombre de lignes de mots, commandée par le décodeur 204 ou 204'. De même, toutes cellules d'une même colonne de la matrice 203 ou 203' sont reliées à une même ligne de bit (BL1, BL2, etc.) commandée par le décodeur 206 ou 206'. Les décodeurs 206 ou 206' sont eux-mêmes reliés à un, ou plusieurs, circuits de calcul 212.

Les cellules mémoire 400 comprennent chacune un élément résistif, semblable aux éléments résistifs 302, 304 et 306 décrits en relation avec la figure 3. L'élément résistif de chaque cellule 400 est relié par ses électrodes à une ligne de bit et à la source, ou au drain, d'un transistor, semblable aux transistors 308, 310 et 312 décrits en relation avec la figure 3. Chaque transistor est en outre relié à la masse par son drain, ou sa source et est activé par l'intermédiaire de sa grille par l'activation d'une des lignes de mots.

Ainsi, lorsque le circuit de contrôle 208 commande, par exemple, l'activation de la ligne de mots WL1 et WL2 et l'alimentation de la ligne de bit BL2, des cellules mémoire 402 et 404, située en première et deuxième lignes de la deuxième colonne de la matrice 203 ou 203' sont alimentées. En particulier, les cellules mémoire 402 et 404 sont, par exemple, alimentées simultanément. Autrement dit, les cellules mémoire 402 et 404 sont chacune alimentée, en même temps, par un courant d'entrée, le courant d'entrée appliqué à la cellule mémoire 402 étant, par exemple, différent de celui appliqué à la cellule mémoire 404. Les cellules 402 et 404 forment alors, par exemple, un ensemble de chemins de lecture. A titre d'exemple, en relation avec la figure 1, les cellules 402 et 404 forment l'ensemble comprenant les neurones 116 et 118 et fournissant les valeurs IN"2 et IN"3 au neurone 122 de la couche 106.

La personne du métier saura organiser les cellules mémoire des matrices 203 et 203' de sorte que l'activation des lignes de mots et de bits alimente bien les cellules mémoire voulues. En effet, par exemple, afin d'alimenter la cellule sur la première ligne et première colonne et la cellule sur la deuxième ligne, deuxième colonne, les lignes de mots WL1 et WL2, ainsi que les lignes de bits BL1 et BL2 vont être activées. Par conséquent, les cellules sur la première ligne, deuxième colonne, et sur la deuxième ligne, première colonne, vont aussi être alimentées et contribuer au courant fourni au circuit de calcul 212.

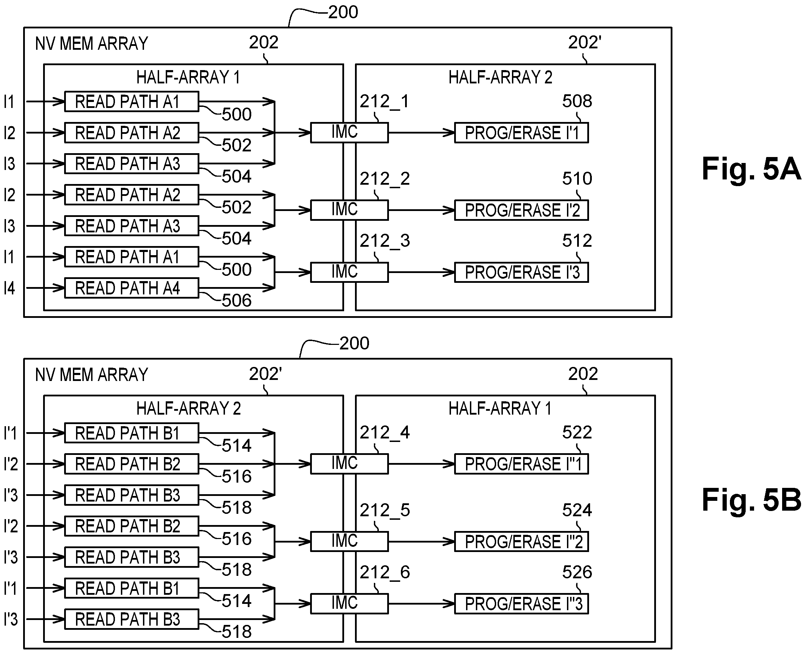

La figure 5A illustre des calculs effectués entre les couches 102 et 104 du réseau de neurones 100, selon un mode de réalisation de la présente description. En particulier, la figure 5A illustre la mise en oeuvre, par la mémoire non volatile 200, des opérations entre les couches 102 et 104.

Un signal de contrôle I1, correspondant à la valeur d'entrée IN1 est fourni, par l'intermédiaire d'une des lignes de mots, par exemple WL1, à une cellule mémoire 500 implémentant le neurone 108 (READ PATH A1). Le signal de contrôle I1 est par exemple configuré pour contrôler la grille d'un transistor sur une ou plusieurs lignes de mot. A titre d'exemple, le signal de contrôle I1 est basé sur une valeur de tension. Dans un autre exemple, le signal de contrôle est un signal de commande de type PWM (de l'anglais « Pulse Width Modulation ») basé sur un rapport cyclique. L'élément résistif de la cellule 500 a été programmé en amont à une valeur encodant le poids A1. De même, des signaux I2, I3 et I4 sont respectivement fournis, par l'intermédiaire de lignes de mots, par exemple la ligne de mots WL2, et des lignes de mots WL3 et WL4 (non illustrées), à des cellules mémoire 502, 504 et 506 implémentant les neurones 110 (READ PATH A2), 112 (READ PATH A3) et 114 (READ PATH A4). Les éléments résistifs des cellules 502, 504 et 506 ont été, respectivement, programmés en amont à des valeurs encodant les poids A2, A3 et A4.

Les sorties des cellules mémoire 500, 502 et 504 sont, par exemple, fournies à un circuit de calcul 212_1. Le circuit de calcul 212_1 est alors configuré pour générer une valeur d'entrée, sur la base des sorties des cellules 500, 502 et 504, pour la cellule mémoire implémentant le neurone 116 et compris dans la matrice 203'. La valeur générée, encodant par exemple un signal I'1, est alors programmée dans un élément résistif 508 (PROG/ERASE I'1) semblable à l'élément résistif 318. Le signal I'1 est ainsi lu et réutilisé comme entrée du décodeur de mots 204.

De manière similaire, les sorties des cellules mémoire 502 et 504, et respectivement des cellules 500 et 506 sont, par exemple, fournies à un circuit de calcul 212_2, et 212_3. Le circuit de calcul 212_2, respectivement le circuit 212_3, est alors configuré pour générer une valeur d'entrée, sur la base des sorties des cellules 502 et 504, respectivement des cellules 500 et 506, pour la cellule mémoire implémentant le neurone 118, respectivement 120 et compris dans la matrice 203'. La valeur générée, encodant par exemple un signal I'2, respectivement un signal I'3, est alors programmée dans un élément résistif 510 (PROG/ERASE I'2), respectivement 512 (PROG/ERASE I'3) . Le signal I'2, respectivement le signal I'3, est ainsi lu et réutilisé comme entrée du décodeur de mots 204.

Le circuit de contrôle 208 est, par exemple, configuré pour, tout d'abord, commander l'alimentation de l'ensemble de chemins de lecture formé par les cellules 500, 502 et 504 et relié au circuit de calcul 212_1. Une fois les sorties des cellules 500, 502 et 504 fournies au circuit de calcul 212_1, le circuit de contrôle 208 commande, par exemple en parallèle, l'alimentation de l'ensemble des chemins formé par les cellules 502 et 504 et relié au circuit de calcul 212_2 et de l'ensemble des chemins formé par les cellules 514 et 518 et relié au circuit de calcul 212_3. En effet, l'alimentation en parallèle des deux ensembles de chemins est possible car ces deux ensembles de chemins de lecture ne comprennent pas de cellule mémoire en commun.

La figure 5B illustre des calculs effectués entre les couches 104 et 106 du réseau de neurones 100, selon un mode de réalisation de la présente description. En particulier, la figure 5B illustre la mise en oeuvre, par la mémoire non volatile 200 des opérations entre les couches 104 et 106, par exemple suite à la programmation des éléments résistifs 508, 510 et 512.

Le signal I'1 est fourni, par l'intermédiaire d'une des lignes de bits de la zone 202' à une cellule mémoire 514 (READ PATH B1) implémentant le neurone 116. L'élément résistif de la cellule 514 a été programmé, en amont, à une valeur encodant le poids B1. De même, les signaux I'2 et I'3 sont respectivement fournis, par l'intermédiaire de lignes de mots de la zone 202', à des cellules mémoire 516 (READ PATH B2) et 518 (READ PATH B3) implémentant les neurones 118 et 120. Les éléments résistifs des cellules 516 et 518 ont été, respectivement, programmés en amont à des valeurs encodant les poids B2 et B3.

Les sorties des cellules mémoires 514, 516 et 518 sont, par exemple, fournies à un circuit de calcul 212_4. Le circuit de calcul 212_4 est alors configuré pour générer une valeur d'entrée, sur la base des sorties des cellules 514, 516 et 518, pour la cellule mémoire implémentant le neurone 122 et compris dans la matrice 203. La valeur générée, correspondant par exemple à un signal I"1, est alors programmée dans un élément résistif 522 (PROG/ERASE I"1) semblable à l'élément résistif 318. A titre d'exemple, la programmation de la valeur générée s'effectue suite à la suppression d'une valeur déjà stocké dans l'élément 522. Le signal I"1 est ainsi lu et réutilisé comme entrée du décodeur de mots 204.

De manière similaire, les sorties des cellules mémoire 516 et 518, et respectivement des cellules 514 et 518, sont par exemple fournies à un circuit de calcul 212_5, et 212_6. Le circuit de calcul 212_5, respectivement le circuit 212_6, est alors configuré pour générer une valeur d'entrée, sur la base des sorties des cellules 516 et 518, respectivement des cellules 514 et 518, pour la cellule mémoire implémentant le neurone 124, respectivement 126, et compris dans la matrice 203. La valeur générée, encodant par exemple un signal I"2, respectivement un signal I"3, est alors programmée dans un élément résistif 524 (PROG/ERASE I"2), respectivement 526 (PROG/ERASE I"3). Le signal I"2, respectivement le signal I"3, est ainsi lu et réutilisé comme entrée du décodeur de mots 204.

Le circuit de contrôle 208 est par exemple configuré pour tout d'abord commander l'alimentation de l'ensemble de chemins formé par les cellules 514, 516 et 518 et relié au circuit de calcul 212_4. Le circuit de contrôle 208 est ensuite configuré pour commander l'alimentation de l'ensemble de chemins formé par les cellules 516 et 518 et relié au circuit de calcul 212_5, puis l'alimentation de l'ensemble de chemins formé par les cellules 514 et 518 et relié au circuit de calcul 212_6. Chacun des ensembles ayant au moins une cellule mémoire en commun avec un des autres ensembles, l'alimentation s'effectue ensemble après ensemble.

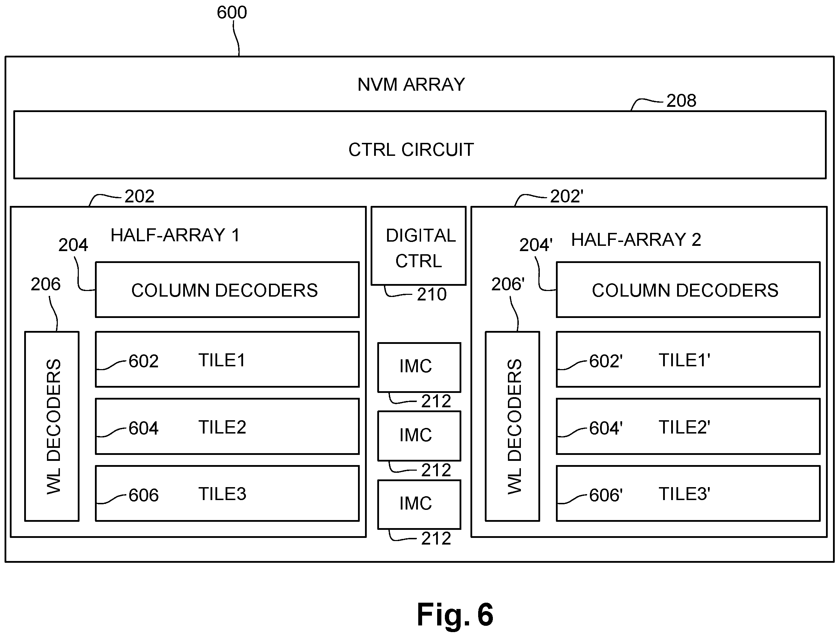

La figure 6 est un schéma par bloc illustrant une mémoire non volatile 600, selon un mode de réalisation de la présente description. En particulier, la mémoire volatile 600 est semblable à la mémoire non volatile 200 excepté en ce que la matrice 203 est remplacée par, ou comprend, des sous matrices 602 (TILE 1), 604 (TILE 2) et 606 (TILE 3). De même, la matrice 203' est remplacée par, ou comprend, des sous matrices 602' (TILE 1'), 604' (TILE 2') et 606' (TILE 3'). Bien que trois sous matrices soient illustrées en figure 6, un nombre supérieur, ou inférieur, à trois sous matrices peut remplacer, ou être compris dans, les matrices 203 et 203'.

A titre d'exemple, chaque sous matrice comprend les cellules mémoire d'un ensemble de chemins de lecture. Dans un autre exemple, chaque sous matrice comprend les cellules mémoire de plusieurs ensembles de chemins de lecture n'ayant aucune cellule mémoire en commun. Ainsi, à titre d'exemple, la cellule mémoire 500 est, par exemple, dupliquée dans la sous matrice 602 et dans la sous matrice 606. De manière générale, chaque cellule mémoire apparaissant dans au moins deux ensembles de chemins de lecture est dupliquée dans des sous matrices.

L'implémentation en sous matrices et la duplication des cellules mémoire communes à plusieurs ensembles de chemins de lecture permet l'alimentation, et la fourniture des sorties de chaque ensemble de chemins au circuit de calcul associé, en parallèle.

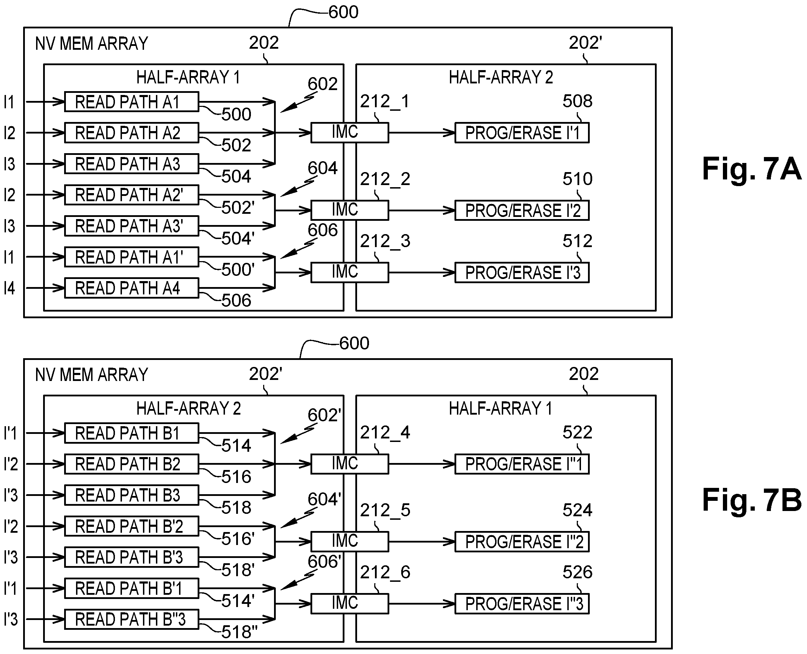

La figure 7A illustre un exemple des calculs effectués entre les couches 102 et 104 du réseau de neurones 100, selon un mode de réalisation de la présente description. En particulier, la figure 7A illustre la mise en oeuvre, par la mémoire non volatile 600, des opérations entre les couches 102 et 104.

A titre d'exemple, la cellule mémoire 500 est par exemple comprise dans la sous matrice 602, et est dupliquée en une cellule 500' comprise dans la sous matrice 606. De même, les cellules 502 et 504 comprises dans la sous matrice 602 sont dupliquées en des cellules 502' et 504' comprises dans la sous matrice 604. La cellule mémoire 506 étant comprise dans un unique ensemble de chemins, celle-ci n'est, par exemple, pas dupliquée et est implémenté uniquement dans la sous matrice 606.

L'alimentation des ensembles de chemins et la fourniture des sorties, vers les circuits de calcul 212_1, 212_2 et 212_3 s'effectue alors en parallèle.

La figure 7B illustre un exemple des calculs effectués entre les couches 104 et 106 du réseau de neurones 100, selon un mode de réalisation de la présente description. En particulier, la figure 7B illustre la mise en oeuvre, par la mémoire non volatile 600 des opérations entre les couches 104 et 106, par exemple suite à la programmation des éléments résistifs 508, 510 et 512.

A titre d'exemple, la cellule mémoire 514 est comprise dans la sous matrice 602', et est dupliquée en une cellule 514' comprise dans la sous matrice 606'. De même, la cellules 516 comprise dans la sous matrice 602' est dupliquée en une cellule 516' comprise dans la sous matrice 604'. La cellule mémoire 518 étant en commun aux trois ensembles de chemins illustrés en relation avec la figure 5B, elle est dupliquée en une cellule 518' comprise dans la sous matrice 604' et en une cellule 518'', comprise dans la sous matrice 606'.

L'alimentation des ensembles de chemins et la fourniture des sorties, vers les circuits de calcul 212_4, 212_5 et 212_6 s'effectue alors en parallèle.

Un avantage des modes de réalisation décrits est que l'ensemble des calculs effectués par le réseau de neurones s'effectue au sein de la mémoire non volatile. Ainsi, il n'y a pas de temps de latence dû au transfert de données entre une mémoire et un processeur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus. En particulier, pour ce qui est de l'arrangement des différentes cellules mémoires, et en particulier la programmation des éléments résistifs, est à la portée de la personne du métier.

## Revendications

1. Mémoire non volatile (200, 600) comprenant :
- une première zone (202) comprenant une première pluralité d'éléments de stockage (400) configurés pour stocker des valeurs de poids associés à une première pluralité de neurones d'un réseau de neurones ;
- une deuxième zone (202') comprenant une deuxième pluralité d'éléments de stockage ;
- un circuit de contrôle (208), configuré pour appliquer, à une pluralité de premiers chemins de lecture (300), un ou plusieurs premières valeurs d'entrée, chaque premier chemin de lecture comprenant l'un parmi les éléments de stockage de la première pluralité d'éléments de stockage (400) et étant configuré pour générer un courant intermédiaire sur la base d'une des premières valeurs d'entrée ;
- un premier circuit de calcul (212_1) configuré pour additionner les courants intermédiaires fournis par les premiers chemins de lecture pour générer un premier courant de sortie ; et
- un circuit de programmation (314, 316) configuré pour convertir le premier courant de sortie en premier courant de programmation, et pour programmer un premier élément de stockage de la deuxième pluralité d'éléments de stockage en utilisant ledit premier courant de programmation.

2. Mémoire non volatile selon la revendication 1, dans laquelle l'une ou plusieurs premières valeurs d'entrée sont appliquées de manière simultanée aux premiers chemins de lecture.

3. Mémoire non volatile selon la revendication 1 ou 2, dans laquelle le circuit de contrôle (208) est en outre configuré pour appliquer, à une pluralité de deuxièmes chemins de lecture, une ou plusieurs deuxième valeurs d'entrée générées en lisant le premier élément de la deuxième pluralité d'éléments de stockage, chaque deuxième chemin de lecture comprenant l'un parmi les éléments de stockage de la deuxième pluralité d'éléments de stockage (400),
la mémoire non volatile (200, 600) comprenant en outre
- un deuxième circuit de calcul (212), configuré pour additionner des courants fournis par les deuxièmes chemins de lecture pour générer un deuxième courant de sortie, le circuit de programmation (314, 316) étant configuré pour convertir le deuxième courant de sortie en deuxième courant de programmation, et de programmer un autre élément de stockage de la première zone (202) de la mémoire en utilisant ledit deuxième courant de programmation.

4. Mémoire non volatile (200, 600) selon la revendication 3, dans laquelle le circuit de contrôle (208) est en outre configuré pour appliquer, à une pluralité de troisièmes chemins de lecture, une ou plusieurs troisième valeurs d'entrée générées en lisant l'autre élément de stockage de la première zone, chaque troisième chemin de lecture comprenant l'une parmi les éléments de stockage de la première pluralité d'éléments de stockage, et dans laquelle le premier circuit de calcul est en outre configuré pour additionner des courants fournis par les troisièmes chemins de lecture pour générer un troisième courant de sortie, le circuit de programmation étant en outre configuré pour convertir le troisième courant de sortie en troisième courant de programmation, et de reprogrammer le premier élément de stockage de la deuxième pluralité d'éléments de stockage en utilisant ledit troisième courant de programmation.

5. Mémoire non volatile (200, 600) selon la revendication 3, dans laquelle les éléments de stockage compris dans les premiers chemins de lecture (300) définissent les poids associés à une couche d'entrée (102) du réseau de neurones (100) et dans laquelle les éléments de stockage compris dans les troisièmes chemins de lecture définissent les poids associés à une autre couche, ou à une couche de sortie (106), du réseau de neurones.

6. Mémoire non volatile (200, 600) selon l'une quelconque des revendications 1 à 5, dans laquelle les poids stockés par la première pluralité d'éléments de stockage (302, 304, 306) définissent des poids de neurones appartenant à des couches (102, 106) de parité impaire, respectivement de parité paire, du réseau de neurones et les poids stockés par la deuxième pluralité d'éléments de stockage définissent des poids de neurones appartenant à des couches de parité paire (104), respectivement de parité impaire, du réseau de neurones.

7. Mémoire non volatile (200, 600) selon l'une quelconque des revendications 1 à 6, dans laquelle chaque élément de stockage (302, 304, 306), parmi la première et la deuxième pluralité d'éléments de stockage, appartient à une cellule mémoire (400), chaque cellule mémoire étant reliée au circuit de contrôle par l'intermédiaire d'une ligne de mot (WL1, WLN) et d'une ligne de bit (BL1, BL2), le circuit de contrôle (208) étant configuré pour activer ou désactiver des lignes de mots et des lignes de bits.

8. Mémoire non volatile (200, 600) selon l'une quelconque des revendications 1 à 7, dans laquelle le premier circuit de calcul (212_1) est configuré pour générer la première valeur de sortie, sur la base des courants fournis par les cellules mémoire (400) comprises dans un chemin de lecture parmi les premiers chemins de lecture.

9. Mémoire non volatile (200, 600) selon l'une quelconque des revendications 1 à 8, dans laquelle le circuit de calcul (212) est en outre configuré pour appliquer des effets de compensation et/ou de seuil et/ou de décalage et/ou de mise à l'échelle, sur la base des courants fournis par les cellules mémoire comprises dans un chemin de lecture parmi les premiers chemins de lecture.

10. Mémoire non volatile (200, 600) selon l'une quelconque des revendications 1 à 9, dans lequel les éléments de stockage (302, 304, 306) et les autres éléments de stockages (318) sont des éléments résistifs programmables.

11. Mémoire non volatile (200, 400) selon l'une quelconques des revendications 1 à 10, comprenant en outre un troisième circuit de calcul (212_3) configuré pour générer une autre valeur de sortie, sur la base de courants fournis par une ou plusieurs cellules mémoire comprises dans un chemin de lecture parmi les premiers chemins de lecture et de l'une ou plusieurs premières valeurs d'entrée.

12. Mémoire non volatile (600) selon la revendication 11, dans laquelle le premier et le troisième circuits de calcul (212_1, 212_3) sont configurés pour générer les valeurs de sortie sur la base d'une ou plusieurs cellules en commun dans la pluralité de premiers chemins de lecture, les cellules en commun étant dupliquées dans au moins deux sous-zones (602, 604,606) dans la première zone (202).

13. Procédé comprenant :
- l'application, par un circuit de contrôle (208) à une pluralité de premiers chemins de lecture (300), une ou plusieurs premières valeurs d'entrée, chaque premier chemin de lecture comprenant l'une parmi des éléments de stockage d'une première pluralité d'éléments de stockage (400) d'une première zone d'une mémoire non volatile et étant configuré pour générer un courant intermédiaire sur la base d'une des premières valeurs d'entrée, la première pluralité d'éléments de stockage (400) étant configurés pour stocker des valeurs de poids associés à une première pluralité de neurones d'un réseau de neurones ;
- additionner, par un premier circuit de calcul (212_1), les courants intermédiaires fournis par les premiers chemins de lecture pour générer un premier courant de sortie ;
- convertir, par un circuit de programmation (314, 316), le premier courant de sortie en premier courant de programmation, et programmer, par le circuit de programmation (314, 316), un premier élément de stockage d'une deuxième pluralité d'éléments de stockage d'une deuxième zone de la mémoire non volatile en utilisant ledit premier courant de programmation.

14. Procédé selon la revendication 13, comprenant en outre :
- l'application, par le circuit de contrôle (208) à une pluralité de deuxièmes chemins de lecture, d'une ou plusieurs deuxième valeurs d'entrée générées en lisant le premier de la deuxième pluralité d'éléments de stockage, chaque deuxième chemin de lecture comprenant l'une parmi les éléments de stockage de la deuxième pluralité d'éléments de stockage (400),
- additionner, par un deuxième circuit de calcul (212), des courants fournis par les deuxièmes chemins de lecture pour générer un deuxième courant de sortie ;
- convertir, par le circuit de programmation (314, 316), le deuxième courant de sortie en deuxième courant de programmation, et programmer, par le circuit de programmation (314, 316), un autre élément de stockage de la première zone (202) de la mémoire en utilisant ledit deuxième courant de programmation.
